# FASCICULE DE BREVET EUROPEEN

(11) **EP 1 388 175 B1**
(45) Date de publication et mention de la délivrance du brevet: **25.07.2007**
(21) Numéro de dépôt: 02740797.2
(22) Date de dépôt: 17.05.2002
(51) Int. Cl.: H01L 31/0203, H01L 31/0232, H01L 27/146

(54) **BOITIER SEMI-CONDUCTEUR OPTIQUE A LENTILLE INCORPOREE ET BLADAGE**
GEHÄUSE FÜR EINEN OPTISCHEN HALBLEITER MIT EINGEBETTETER LINSE UND ABSCHIRMVORRICHTUNG
OPTICAL SEMICONDUCTOR HOUSING WITH INCORPORATED LENS AND SHIELDING

(30) Priorité: 18.05.2001 FR 0106553
(43) Date de publication de la demande: 11.02.2004
(73) Titulaire: STMicroelectronics S.A., 92120 Montrouge (FR)
(72) Inventeur: BRECHIGNAC, Rémi, F-38000 Grenoble (FR); EXPOSITO, Juan, F-38330 Saint Nazaire les Eymes (FR)
(74) Mandataire: Casalonga, Axel
(86) Numéro de dépôt international: PCT/FR2002/001689
(87) Numéro de publication internationale: WO 2002/095796

(56) Documents cités:
- EP-A- 0 230 336
- EP-A- 0 807 976
- EP-A- 0 948 059
- US-A- 4 562 350
- US-A- 5 150 180
- PATENT ABSTRACTS OF JAPAN vol. 1998, no. 05, 30 avril 1998 (1998-04-30) & JP 10 004510 A (SONY CORP), 6 janvier 1998 (1998-01-06)
- PATENT ABSTRACTS OF JAPAN vol. 010, no. 376 (E-464), 13 décembre 1986 (1986-12-13) & JP 61 170075 A (NEC CORP), 31 juillet 1986 (1986-07-31)

## Description

La présente invention concerne le domaine des boîtiers semi-conducteurs optiques.

Dans l'état de la technique, de tels boîtiers comprennent une cavité étanche dans laquelle est fixé un composant semi-conducteur optique dont une face avant présente un capteur optique, la cavité étant délimitée en partie par une vitre s'étendant en avant de ce capteur optique. Il est en outre connu de fixer, à l'extérieur de la cavité et sur la vitre, un porte-lentille muni d'une lentille placée eh face du capteur optique. Compte tenu des tolérances de fabrication dues aux empilages, il est obligatoire de prévoir un réglage de la distance focale entre la lentille et le capteur optique. Pour celà, la lentille est fixée dans une bague et cette bague est vissée de façon réglable dans un passage du porte-lentille.

Un tel boîtier comprend de nombreuses pièces complexes à fabriquer et, après montage, nécessite un réglage de la lentille et une fixation de cette dernière en position réglée, de telle sorte que son coût de fabrication est relativement élevé.

On connaît par ailleurs, par les documents EP-A-0 807 976 et JP-A-10004510, des boîtiers comprenant un composant semi-conducteur optique fixé sur le fond d'une cavité et une lentille interposée entre une paroi avant et la face avant du composant semi-conducteur, cette lentille étant portée par un support fixé sur le fond de la cavité, à distance du composant semi-conducteur. Le positionnement de la lentille par rapport au capteur du composant semi-conducteur est donc dépendant des tolérances de fabrication et des positions relatives du composant semi-conducteur et du support de la lentille par rapport au fond de la cavité, ainsi que des tolérances de fabrication du fond de la cavité.

La présente invention a pour but de proposer un boîtier semi-conducteur optique de structure plus simple et ne nécessitant pas de réglage.

La présente invention a également pour but d'améliorer la qualité des signaux électriques délivrés par le composant semi-conducteur optique.

Le boîtier semi-conducteur optique selon l'invention comprend un composant semi-conducteur optique dont une face avant présente un capteur optique, et des moyens d'encapsulation délimitant une cavité dans laquelle est disposé ledit composant optique et présentant des moyens de connexion électrique extérieure de ce composant semi-conducteur optique, lesdits moyens d'encapsulation comprenant une vitre laissant passer la lumière vers ledit capteur, et comprenant en outre une lentille optique placée dans ladite cavité, entre ledit capteur optique et ladite vitre, et des moyens de support (18) de cette lentille.

Selon l'invention, lesdits moyens de support de ladite lentille sont fixés sur la face avant dudit composant optique, à l'extérieur dudit capteur optique.

Selon l'invention, un anneau de jonction (18a) est de préférence interposé entre un bord avant desdits moyens de support et lesdits moyens d'encapsulation.

Selon l'invention, lesdits moyens de support de ladite lentille comprennent de préférence une bague dans laquelle est fixée ladite lentille et dont l'extrémité arrière est fixée sur la face avant dudit composant optique, à l'extérieur dudit capteur optique.

Selon l'invention, lesdits moyens de support de ladite lentille comprennent de préférence un anneau de jonction interposé entre le bord avant de ladite bague annulaire et lesdits moyens d'encapsulation.

Selon l'invention, lesdits moyens d'encapsulation comprennent de préférence un diaphragme.

Selon une variante de réalisation de l'invention, lesdits moyens d'encapsulation comprennent des moyens de blindage électromagnétique en un matériau conducteur de l'électricité, connectable extérieurement, ces moyens de blindage étant isolés électriquement desdits moyens de connexion électrique dudit composant optique.

Selon l'invention, lesdits moyens d'encapsulation comprennent de préférence un support et un couvercle vitré fixé sur une face frontale de ce support, qui délimitent entre eux ladite cavité, ledit composant optique étant fixé sur ce support et ce dernier présentant un réseau de connexion électrique extérieure de ce composant optique.

Selon une autre variante de l'invention, ledit support est en forme de plaque et ledit couvercle vitré est en forme de cuvette dont le bord périphérique est fixé sur la face frontale de cette plaque et qui présente une ouverture obstruée par ladite vitre.

Selon une autre variante de l'invention, ledit support présente une partie en creux entourée par une partie annulaire et au fond de laquelle ledit composant optique est fixé, et ledit couvercle vitré comprend une plaque vitrée dont la partie périphérique est fixée sur la face frontale de ladite partie annulaire dudit support.

Selon l'invention, ledit support et ledit couvercle vitré comprennent des parties de blindage en un matériau conducteur de l'électricité, reliées entre elles dans la zone de la face frontale dudit support.

Selon l'invention, lesdites parties de blindage dudit couvercle vitré délimitent de préférence un diaphragme.

Selon l'invention, ledit support comprend de préférence au moins un plan de blindage intégré en un matériau conducteur de l'électricité, s'étendant en dessous dudit composant optique, et des colonnes intégrées de blindage en un matériau conducteur de l'électricité, débouchant sur sa face frontale, et ledit couvercle vitré comprend de préférence une partie ou une couche de blindage en un matériau conducteur de l'électricité, reliée électriquement auxdites colonnes de blindage dudit support.

Selon l'invention, ledit couvercle vitré est de préférence fixée sur ledit support par une colle conductrice de l'électricité réalisant sa liaison électrique entre eux.

Selon une exécution de l'invention, ledit couvercle vitré comprend une cuvette en un matériau conducteur de l'électricité.

Selon une autre exécution de l'invention, ledit couvercle vitré comprend une vitre dont une face est recouverte au moins partiellement d'une couche de blindage en un matériau conducteur de l'électricité ménageant une ouverture située en face dudit capteur optique.

Selon une autre exécution de l'invention, ledit couvercle vitré comprend une plaque en un matériau conducteur de l'électricité, qui présente une ouverture située en face dudit capteur optique et obstruée par une vitre.

La présente invention sera mieux comprise à l'étude de différents boîtiers semi-conducteurs optiques décrits à titre d'exemples non limitatifs et illustrés par le dessin sur lequel :
- la figure 1 représente une coupe d'un premier boîtier semi-conducteur optique selon la présente invention ;
- la figure 2 représente une vue de dessus, vitre enlevée, du boîtier semi-conducteur optique de la figure 1 ;
- la figure 3 représente une vue de dessus du boîtier semi-conducteur optique de la figure 1 ;
- la figure 4 représente une coupe d'un second boîtier semi-conducteur optique selon la présente invention ;
- la figure 5 représente une vue de dessus, vitre enlevée, du boîtier semi-conducteur optique de la figure 1 ;
- la figure 6 représente une coupe d'un troisième boîtier semi-conducteur optique selon la présente invention ;
- et la figure 7 représente une coupe d'un quatrième boîtier semi-conducteur optique selon la présente invention.

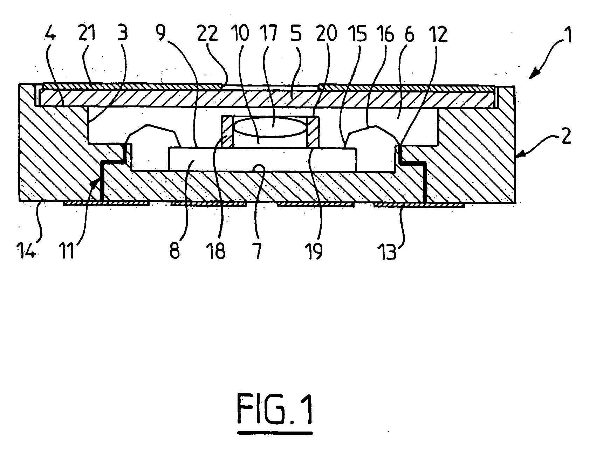

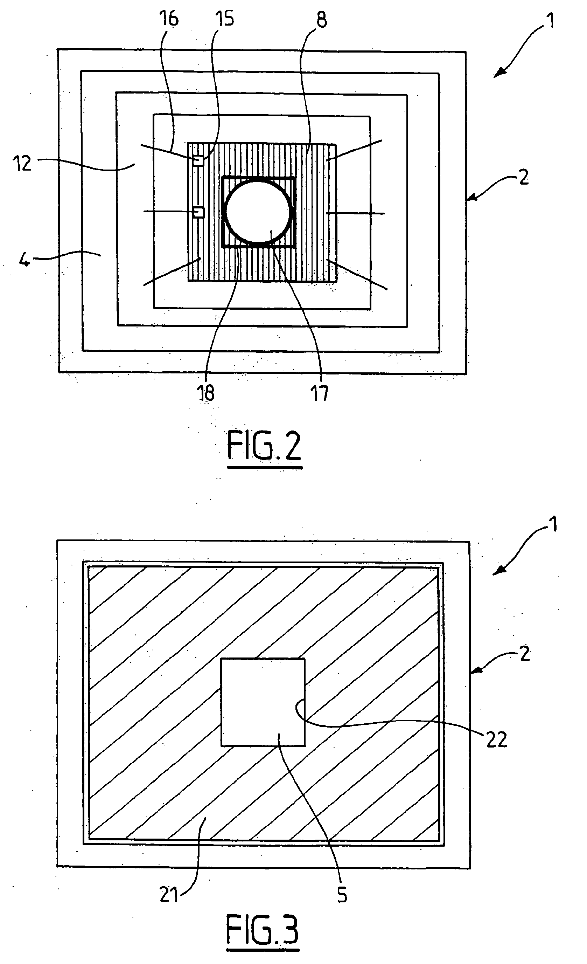

En se reportant aux figures 1 à 3, on voit qu'on a représenté un boîtier semi-conducteur optique 1 qui comprend un support 2 de forme parallélipipédique et plat, dans une face duquel est ménagé un évidement en creux 3, de telle sorte que ce support 2 présente, autour de cet évidement, une face frontale annulaire 4.

Le boîtier optique 1 comprend en outre un couvercle vitré constitué par une vitre transparente 5 dont la périphérie de la face arrière est en appui et fixée contre la face frontale 4 du support 2, par exemple par une colle. Ainsi, le support 2 et la vitre 5 délimitent une cavité étanche d'encapsulation 6.

Dans cette cavité 6 est disposé un composant semi-conducteur optique 8. La face arrière du composant optique 8 est fixée, par exemple par une colle, contre le fond 7 de l'évidement 3 du support 2 et sa face avant 9, qui s'étend à distance et parallèlement à la vitre 5, présente, dans sa partie centrale, un capteur optique 10 couvrant par exemple une zone carrée.

Le support 2, constitué par exemple en une matière organique ou céramique multi-couches, présente un réseau interne 11 d'inter-connexion électrique. Ce réseau 11 relie des plots internes 12 placés et répartis sur la paroi de l'évidement 3 du support 2, à distance et à la périphérie du composant optique 8, et des plots externes 13 de connexion électrique extérieure placés et répartis sur la face arrière 14 du support 2.

Le composant optique 8 présente sur sa face avant 9, à faible distance de sa périphérie et à distance du capteur optique 10, des plots avant 15 de connexion électrique.

Les plots internes 12 du support 2 et les plots avant 15 du composant optique 9 sont reliés par des fils électriques 16 dont les extrémités sont soudées sur ces plots. Le composant optique 8 peut ainsi être relié à un organe électrique extérieur au travers du support 2, via le réseau 11 et les fils électriques 16.

Le boîtier 1 comprend en outre une lentille optique 17 disposée dans la cavité 6, entre la vitre 5 et le capteur optique 10.

Cette lentille 17 est fixée dans une bague 18, par exemple cylindrique, dont l'axe s'étend perpendiculairement à la face avant 9 du composant optique 8 et dont le bord annulaire d'extrémité arrière 19 est fixé par exemple par une colle sur cette face avant 9, entre la zone constituant le capteur optique 10 et les plots avant 15, le bord annulaire d'extrémité avant 20 de la bague 18 étant à faible distance de la vitre 5 ou en contact avec cette dernière.

Par ailleurs, la face avant de la vitre 5 est recouverte d'une couche opaque 21, ménageant une ouverture 22 dans sa partie située en face de la lentille 17 de façon à constituer un diaphragme.

Ainsi, la lumière extérieure passe au travers du diaphragme 22, de la vitre 5 dans sa partie correspondante, au travers de la lentille 17 par l'intérieur de la bague 18, pour enfin atteindre le capteur optique 10, le capteur optique 8 pouvant délivrer les signaux électriques correspondants à l'extérieur sur les plots extérieurs 16 via les fils électriques 16 et le réseau 11 du support 2.

Le boîtier semi-conducteur optique 1 peut être fabriqué de la manière suivante.

Disposant du support 2, on fixe par une colle adaptée la face arrière du composant semi-conducteur optique 8 sur le fond 7 de son évidement 3.

On relie électriquement le support 2 au composant optique 8 en soudant les extrémités des fils 16 sur leurs plots 12 et 15.

On fixe par l'intermédiaire d'une colle adaptée la bague 18, préalablement munie de la lentille 17, sur la face avant 9 du composant optique 8, la position souhaitée de la lentille 17 par rapport au capteur optique 10 étant ainsi directement obtenue.

Enfin, on installe et on fixe grâce à une colle adaptée la vitre 5 munie de la couche 21 sur la face frontale 4 du support 2.

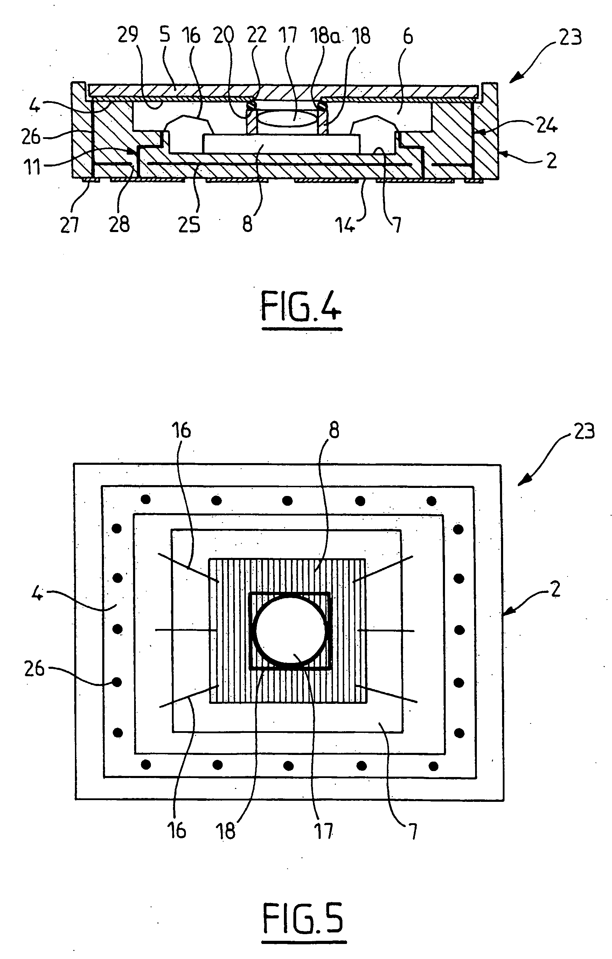

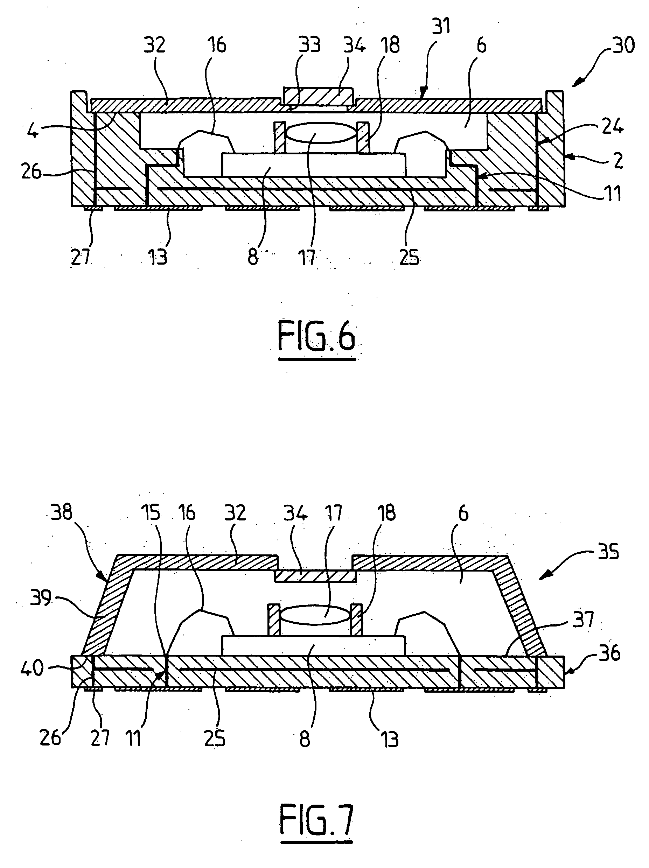

En se reportant aux figures 4 et 5, on voit qu'on a représenté un boîtier semi-conducteur optique 23 qui ne se différencie du boîtier semi-conducteur optique 1 décrit en référence aux figures 1 à 3, uniquement par le fait qu'il comprend des moyens de blindage électromagnétique 24, électriquement isolés du réseau de connexion électrique 11 du support 2.

Pour celà, le support 2 comprend en outre un plan intégré 25 en un matériau conducteur de l'électricité, par exemple métallique, qui s'étend parallèlement à sa face arrière 14 et une multiplicité de colonnes intégrées 26 en un matériau conducteur de l'électricité, par exemple métallique, qui sont réparties dans le volume périphérique du support 2 et qui sont reliées au plan conducteur 25. Ces colonnes conductrices 26 débouchent sur la face frontale 4 du support 2 et au moins une de ces colonnes débouche sur la face arrière 14 du support 2 de façon à constituer au moins un plot de connexion électrique extérieure 27.

Dans le support 2, le plan conducteur intégré 25 et les colonnes conductrices intégrées 26 sont agencés de façon à ne pas être en contact avec le réseau intégré d'inter-connexion 11. En particulier, le plan conducteur 25 présente des passages traversants 28 au travers desquels passent les lignes d'interconnexion du réseau 11.

En outre, la vitre 5 porte, sur sa face arrière tournée vers la cavité 6, une couche opaque 29 en un matériau conducteur de l'électricité, sauf dans sa partie située en face de la lentille 17 de façon à constituer le diaphragme 22, la couche extérieure 21 de l'exemple précédent pouvant être supprimée.

Avantageusement, la périphérie de la vitre 5 est fixée sur la face frontale 4 du support 2 grâce à une colle conductrice de l'électricité de telle sorte que la couche conductrice 29 portée par la vitre 5 est reliée électriquement aux colonnes conductrices 4 du support 2.

Il résulte de ce qui précède qu'en reliant le plot extérieur 27 à une masse, de préférence indépendante de la masse du composant optique 8, les moyens de blindage 24 constitués par le plan conducteur 25, les colonnes conductrices 26 et la couche conductrice 29 constituent une cage d'isolation électromagnétique du composant semi-conducteur optique 8.

Dans cette variante, un anneau de jonction 18a est interposé entre le bord annualaire avant 20 de la bague 18 et la face arrière de la vitre 5, autour du diaphragme 22.

En se reportant à la figure 6, on voit qu'on a représenté un boîtier semi-conducteur optique 30 qui se différencie du boîtier semi-conducteur optique 23 décrit en référence aux figures 4 et 5 uniquement par le fait que la vitre 5 munie de la couche conductrice 29 est remplacée par un couvercle vitré 31 qui comprend une plaque opaque 32 en un matériau conducteur de l'électricité, par exemple en métal, qui présente une ouverture 33 située en face de la lentille 17 et constituant le diaphragme 22 précité, cette ouverture 33 étant obstruée par une vitre transparente 34 dont la périphérie est par exemple collée sur la plaque 32.

Comme dans l'exemple précédent, la périphérie de la plaque 32 est fixée sur la face frontale 4 du support 2 par l'intermédiaire d'une colle conductrice de telle sorte qu'elle est reliée électriquement aux colonnes conductrices 26.

En se reportant à la figure 7, on voit qu'on a représenté un boîtier semi-conducteur 35 qui se différencie de ceux décrits dans les exemples précédents par le fait que son support d'inter-connexion 36,
correspondant au support d'inter-connexion 2, est constitué par une plaque plate dont la face avant 37 porte le composant semi-conducteur optique 8 et présente les plots internes 15.

Ce boîtier optique 35 comprend un couvercle vitré 38 en forme de cuvette dont le bord est fixé sur la face avant 37 de la plaque 36 de façon à délimiter la cavité étanche 6.

Le fond de cette cuvette 38 est constituée de la plaque 32 et de la vitre 34 décrite en référence à la figure 6 et sa paroi latérale 39 est constituée par un prolongement périphérique de cette plaque 32 dont le bord 40 est fixé sur la face avant 37 de la plaque 36 par une colle conductrice de façon à être reliée électriquement aux colonnes conductrices 26 intégrées dans le support 36.

La présente invention ne se limite pas aux exemples ci-dessus décrits. Bien des variantes de réalisation sont possibles sans sortir du cadre defini par les revendications annexées.

## Revendications

1. Boîtier semi-conducteur optique comprenant un composant semi-conducteur optique (8) dont la face avant (9) présente un capteur optique, et des moyens d'encapsulation délimitant une cavité (6) sur le fond de laquelle est fixée la face arrière dudit composant optique et présentant des moyens de connexion électrique extérieure (11) de ce composant semi-conducteur optique, lesdits moyens d'encapsulation comprenant une vitre (5) laissant passer la lumière vers ledit capteur optique, et comprenant en outre une lentille optique (17) placée dans ladite cavité (6), entre ledit capteur optique (10) et ladite vitre (5), et des moyens de support (18) de cette lentille, **caractérisé par le fait que** lesdits moyens de support (18) de ladite lentille optique (17) sont fixés sur la face avant (9) dudit composant optique (8), à l'extérieur dudit capteur optique (10).

2. Boîtier selon la revendication 1, **caractérisé par le fait qu'**un anneau de jonction (18a) est interposé entre un bord avant desdits moyens de support et lesdits moyens d'encapsulation (5).

3. Boîtier selon l'une des revendications 1 et 2, **caractérisé par le fait que** lesdits moyens de support de ladite lentille comprennent une bague annulaire (18) dans laquelle est fixée ladite lentille (17) et dont l'extrémité arrière est fixée sur la face avant dudit composant optique (8), à l'extérieur dudit capteur optique (10).

4. Boîtier selon la revendication 3, **caractérisé par le fait que** lesdits moyens de support de ladite lentille comprennent un anneau de jonction (18a) interposé entre le bord avant de ladite bague annulaire (18) et lesdits moyens d'encapsulation (5).

5. Boîtier selon l'une quelconque des revendications précédentes, **caractérisé par le fait que** lesdits moyens d'encapsulation comprennent un diaphragme (22).

6. Boîtier selon l'une quelconque des revendications précédentes, **caractérisé par le fait que** lesdits moyens d'encapsulation comprennent des moyens de blindage électromagnétique (24) en un matériau conducteur de l'électricité, connectable extérieurement, ces moyens de blindage étant isolés électriquement desdits moyens de connexion électrique (11) dudit composant optique (8).

7. Boîtier selon l'une quelconque des revendications précédentes, **caractérisé par le fait que** lesdits moyens d'encapsulation comprennent un support (2 ; 36) et un couvercle vitré (5 ; 31 ; 38) fixé sur une face frontale (4 ; 37) de ce support, qui délimitent entre eux ladite cavité (6), ledit composant optique (8) étant fixé sur ce support et ce dernier présentant un réseau de connexion électrique extérieure (11) de ce composant optique.

8. Boîtier selon la revendication 7, **caractérisé par le fait que** ledit support (2) présente une partie en creux (3) entourée par une partie annulaire et au fond (7) de laquelle ledit composant optique (8) est fixé, et ledit couvercle vitré comprend une plaque vitrée (5 ; 31) dont la partie périphérique est fixée sur la face frontale (4) de ladite partie annulaire dudit support.

9. Boîtier selon la revendication 7, **caractérisé par le fait que** ledit support est en forme de plaque (36) et ledit couvercle vitré est en forme de cuvette (38) dont le bord périphérique est fixé sur la face frontale (37) de cette plaque et qui présente une ouverture obstruée par ladite vitre (34).

10. Boîtier selon l'une quelconque des revendications 7 à 9, **caractérisé par le fait que** ledit support (2 ; 36) et ledit couvercle vitré (5 ; 31 ; 38) comprennent des parties de blindage en un matériau conducteur de l'électricité, reliées entre elles dans la zone de la face frontale (4) dudit support.

11. Boîtier selon la revendication 10, **caractérisé par le fait que** lesdites parties de blindage (21; 32 ; 38) dudit couvercle vitré délimitent un diaphragme (22).

12. Boîtier selon l'une quelconque des revendications 7 à 11, **caractérisé par le fait que** ledit support comprend au moins un plan intégré de blindage (25) en un matériau conducteur de l'électricité, s'étendant en dessous dudit composant optique, et des colonnes intégrées de blindage (26) en un matériau conducteur de l'électricité, débouchant sur sa face frontale (4 ; 37), et que ledit couvercle vitré comprend une partie ou une couche de blindage (21 ; 32 ; 39) en un matériau conducteur de l'électricité, reliée électriquement auxdites colonnes de blindage dudit support.

13. Boîtier selon l'une quelconque des revendications 7 à 12, **caractérisé par le fait que** ledit couvercle vitré est fixée sur ledit support par une colle conductrice de l'électricité réalisant sa liaison électrique entre entre eux.

14. Boîtier selon l'une quelconque des revendications 7 à 12, **caractérisé par le fait que** ledit couvercle vitré comprend une cuvette (32, 39) en un matériau conducteur de l'électricité, qui présente une ouverture située en face dudit capteur optique et obstruée par ladite vitre (34).

15. Boîtier selon l'une quelconque des revendications 7 à 12, **caractérisé par le fait que** ledit couvercle vitré comprend une vitre (5) dont une face est recouverte au moins partiellement d'une couche de blindage (21) en un matériau conducteur de l'électricité ménageant une ouverture (22) située en face dudit capteur optique.

16. Boîtier selon l'une quelconque des revendications 7 à 12, **caractérisé par le fait que** ledit couvercle vitré comprend une plaque (32) en un matériau conducteur de l'électricité, qui présente une ouverture située en face dudit capteur optique et obstruée par ladite vitre (34).

## Claims

1. Optical semiconductor package comprising an optical semiconductor component (8), the front face (9) of which has an optical sensor, and encapsulation means that define a cavity (6) to the bottom of which is fastened the rear face of said optical component, and having external electrical connection means (11) for connecting this optical semiconductor component, said encapsulation means comprising a glass pane (5) that lets light through to said optical sensor, and furthermore including an optical lens (17) placed in said cavity (6), between said optical sensor (10) and said glass pane (5), and means (18) for supporting this lens, **characterized in that** said means (18) for supporting said optical lens (17) are fastened to the front face (9) of said optical component (8), to the outside of said optical sensor (10).

2. Package according to Claim 1, **characterized in that** a junction ring (18a) is interposed between a front edge of said supporting means and said encapsulation means (5).

3. Package according to either of Claims 1 and 2, **characterized in that** said means for supporting said lens comprise an annular ring (18) in which said lens (17) is fastened, the rear end of said annular ring being fastened to the front face of said optical component (8), to the outside of said optical sensor (10).

4. Package according to Claim 3, **characterized in that** said means for supporting said lens comprise a junction ring (18a) interposed between the front edge of said annular ring (18) and said encapsulation means (5).

5. Package according to any one of the preceding claims, **characterized in that** said encapsulation means include a diaphragm (22).

6. Package according to any one of the preceding claims, **characterized in that** said encapsulation means include externally connectable electromagnetic screening means (24) made of an electrically conducting material, these screening means being electrically isolated from said electrical connection means (11) for connecting said optical component (8).

7. Package according to any one of the preceding claims, **characterized in that** said encapsulation means include a support (2; 36) and a glass lid (5; 31; 38) fastened to a front face (4; 37) of this support, which between them define said cavity (6), said optical component (8) being fastened to this support and the latter having an array of external electrical connections (11) for connecting this optical component.

8. Package according to Claim 7, **characterized in that** said support (2) has a recessed part (3) surrounded by an annular part, fastened to the bottom (7) of which is said optical component (8), and said glass lid comprises a glass plate (5; 31), the peripheral part of which is fastened to the front face (4) of said annular part of said support.

9. Package according to Claim 7, **characterized in that** said support is in the form of a plate (36) and said glass lid is in the form of a dish (38), the peripheral edge of which is fastened to the front face (37) of this plate and which has an aperture obstructed by said glass pane (34).

10. Package according to any one of Claims 7 to 9, **characterized in that** said support (2; 36) and said glass lid (5; 31; 38) include screening parts made of an electrically conducting material, which are joined together in the region of the front face (4) of said support.

11. Package according to Claim 10, **characterized in that** said screening parts (21; 32; 38) of said glass lid define a diaphragm (22).

12. Package according to any one of Claims 7 to 11, **characterized in that** said support includes at least one integrated screening plane (25) made of an electrically conducting material, extending below said optical component, and integrated screening columns (26) made of an electrically conducting material, which emerge on its front face (4; 37), and **in that** said glass lid includes a screening layer or part (21; 32; 39) made of an electrically conducting material, which is electrically connected to said screening columns of said support.

13. Package according to any one of Claims 7 to 12, **characterized in that** said glass lid is fastened to said support by an electrically conducting adhesive resulting in its electrical connection between them.

14. Package according to any one of Claims 7 to 12, **characterized in that** said glass lid includes a dish (32, 39) made of an electrically conducting material, which has an aperture located facing said optical sensor and obstructed by said glass pane (34).

15. Package according to any one of Claims 7 to 12, **characterized in that** said glass lid comprises a glass pane (5), one face of which is at least partly covered with a screening layer (21) made of an electrically conducting material, leaving an aperture (22) facing said optical sensor.

16. Package according to any one of Claims 7 to 12, **characterized in that** said glass lid comprises a plate (32) made of an electrically conducting material, which has an aperture facing said optical sensor and obstructed by said glass pane (34).

## Patentansprüche

1. Gehäuse für einen optischen Halbleiter mit einem optischen Halbleiterelement (8), dessen vordere Fläche (9) einen optischen Sensor aufweist, und Verkapselungseinrichtungen, welche einen Hohlraum (6) umgrenzen, an dessen Boden die hintere Fläche des optischen Elements angebracht ist, und welche Einrichtungen (11) zum externen elektrischen Anschließen dieses optischen Halbleiterelements aufweisen, wobei die Verkapselungseinrichtungen ein Glas (5) aufweisen, welches das Licht zum optischen Sensor durchläßt, und ferner eine in dem Hohlraum (6) zwischen dem optischen Sensor (10) und der Glasscheibe (5) angeordnete optische Linse (17) und Halteeinrichtungen (18) zum Halten dieser Linse (17) aufweisen,
**dadurch gekennzeichnet, daß**
die Halteeinrichtungen (18) zum Halten der optischen Linse (17) an der vorderen Fläche des optischen Elements (8) außerhalb des optischen Sensors (10) angebracht sind.

2. Gehäuse nach Anspruch 1, **dadurch gekennzeichnet, daß** ein Verbindungsring (18a) zwischen einem vorderen Rand der Halteeinrichtungen und den Verkapselungseinrichtungen (5) angeordnet ist.

3. Gehäuse nach einem der Ansprüche 1 und 2, **dadurch gekennzeichnet, daß** die Halteeinrichtungen der Linse einen Ring (18) aufweisen, in welchem die Linse (17) befestigt ist und dessen hinteres Ende an der vorderen Fläche des optischen Elements (8) außerhalb des optischen Sensors (10) befestigt ist.

4. Gehäuse nach Anspruch 3, **dadurch gekennzeichnet, daß** die Halteeinrichtungen der Linse einen zwischen dem vorderen Rand des Rings (18) und den Verkapselungseinrichtungen (5) angeordneten Verbindungsring (18a) aufweisen.

5. Gehäuse nach einem der vorstehenden Ansprüche, **dadurch gekennzeichnet, daß** die Verkapselungseinrichtungen eine Blende (22) aufweisen.

6. Gehäuse nach einem der vorstehenden Ansprüche, **dadurch gekennzeichnet, daß** die Verkapselungseinrichtungen Einrichtungen (24) zur elektromagnetischen Abschirmung aus einem extern anschließbaren elektrisch leitenden Material aufweisen, wobei diese Abschirmungseinrichtungen elektrisch von den elektrischen Verbindungseinrichtungen (11) des optischen Elements (8) isoliert sind.

7. Gehäuse nach einem der vorstehenden Ansprüche, **dadurch gekennzeichnet, daß** die Verkapselungseinrichtungen einen Träger (2;36) und einen an einer Stirnfläche (4;37) dieses Trägers angebrachten Glasdeckel (5;31;38) aufweisen, die zwischen sich den Hohlraum (6) umgrenzen, wobei das optische Element (8) an diesem Träger angebracht ist und dieser letzere ein Netz (11) zum externen elektrischen Verbinden dieses optischen Elements aufweist.

8. Gehäuse nach Anspruch 7, **dadurch gekennzeichnet, daß** der Träger (2) einen hohlen Abschnitt (3) aufweist, der von einem ringförmigen Abschnitt umgeben ist und an dessen Boden (7) das optische Element (8) angebracht ist, und der Glasdeckel eine Glasplatte (5;31) aufweist, deren peripherer Abschnitt an der Stirnfläche (4) des ringförmigen Abschnitts des Trägers angebracht ist.

9. Gehäuse nach Anspruch 7, **dadurch gekennzeichnet, daß** der Träger in Form einer Platte (36) ist und der Glasdeckel in Form einer Küvette (38) ist, deren peripherer Rand an der Stirnfläche (37) dieser Platte angebracht ist und die eine mit dem Glas (34) verschlossene Öffnung aufweist.

10. Gehäuse nach einem der Ansprüche 7 bis 9, **dadurch gekennzeichnet, daß** der Träger (2;36) und der Glasdeckel (5;31;38) Abschirmungsabschnitte aus einem elektrisch leitenden Material aufweisen, die in der Zone der Stirnfläche (4) des Trägers miteinander verbunden sind.

11. Gehäuse nach Anspruch 10, **dadurch gekennzeichnet, daß** die Abschirmungsabschnitte (21;32;38) des Glasdeckels eine Blende (22) umgrenzen.

12. Gehäuse nach einem der Ansprüche 7 bis 11, **dadurch gekennzeichnet, daß** der Träger mindestens eine sich unterhalb des optischen Elements erstreckende integrierte Abschirmungsebene (25) aus einem elektrisch leitenden Material und integrierte Abschirmungssäulen (26) aus einem elektrisch leitenden Material aufweist, die zu der Stirnseite (4;37) des Trägers führen, und der Glasdeckel einen Abschirmungsabschnitt oder eine Abschirmungsschicht (21;32;39) aus einem elektrisch leitenden Material aufweist, der oder die mit den Abschirmungssäulen des Trägers elektrisch verbunden ist.

13. Gehäuse nach einem der Ansprüche 7 bis 12, **dadurch gekennzeichnet, daß** der Glasdeckel mittels eines elektrisch leitenden Klebstoffs an dem Träger angebracht ist, wobei der Klebstoff die elektrische Verbindung zwischen ihnen bildet.

14. Gehäuse nach einem der Ansprüche 7 bis 12, **dadurch gekennzeichnet, daß** der Glasdeckel eine Küvette (32,39) aus einem elektrisch leitenden Material aufweist, die eine Öffnung aufweist, die dem optischen Sensor gegenüberliegt und mit dem Glas (34) verschlossen ist.

15. Gehäuse nach einem der Ansprüche 7 bis 12, **dadurch gekennzeichnet, daß** der Glasdeckel ein Glas (5) aufweist, dessen Fläche zumindest teilweise mit einer Abschirmungsschicht (21) aus einem elektrisch leitenden Material bedeckt ist, wobei eine Öffnung (22), die dem optischen Sensor gegenüberliegt, ausgespart ist.

16. Gehäuse nach einem der Ansprüche 7 bis 12, **dadurch gekennzeichnet, daß** der Glasdeckel eine Platte (32) aus einem elektrisch leitenden Material aufweist, die eine Öffnung aufweist, die dem optischen Sensor gegenüberliegt und mit dem Glas (34) verschlossen ist.
